# EUROPÄISCHE PATENTSCHRIFT

(11) **EP 0 990 498 B1**
(45) Veröffentlichungstag und Bekanntmachung des Hinweises auf die Patenterteilung: **14.11.2001**
(21) Anmeldenummer: 99116718.0
(22) Anmeldetag: 26.08.1999
(51) Int. Cl.: B28D 5/00, B28D 5/04, B23D 57/00

(54) **Verfahren und Vorrichtung zum Abtrennen einer Vielzahl von Scheiben von einem sprödharten Werkstück**
Method and device for cutting wafers from a hard brittle ingot
Procédé et dispositif de couper des plaquettes d'un lingot dur et cassant

(30) Priorität: 10.09.1998 DE 19841492
(43) Veröffentlichungstag der Anmeldung: 05.04.2000
(73) Patentinhaber: Wacker Siltronic Gesellschaft für Halbleitermaterialien Aktiengesellschaft, 84489 Burghausen (DE)
(72) Erfinder: Huber, Anton, 84489 Burghausen (DE); Junge, Joachim, Dr., 84489 Burghausen (DE); Moser, Jörg, 84508 Burgkirchen (DE)
(74) Vertreter: Rimböck, Karl-Heinz, Dr.

(56) Entgegenhaltungen:
- EP-A- 0 767 036
- EP-A- 0 798 405
- DE-A- 2 718 156
- DE-A- 19 636 055
- DE-A- 19 638 991
- DATABASE WPI Section PQ, Week 9940 Derwent Publications Ltd., London, GB; Class P61, AN 99-472770 XP002128951 & JP 11 198020 A (TOKYO SEIMITSU CO LTD), 27. Juli 1999 (1999-07-27)
- PATENT ABSTRACTS OF JAPAN vol. 1998, no. 10, 31. August 1998 (1998-08-31) & JP 10 138114 A (HITACHI CABLE LTD), 26. Mai 1998 (1998-05-26)

## Beschreibung

Gegenstand der Erfindung ist ein Verfahren zum Abtrennen einer Vielzahl von Scheiben von einem sprödharten Werkstück mit Hilfe einer Drahtsäge. Gegenstand der Erfindung ist auch eine Drahtsäge, die zur Durchführung des Verfahrens geeignet ist. Die Erfindung läßt sich auf alle sprödharten Materialien anwenden, die in Scheiben gesägt werden sollen, insbesondere Halbleitermaterial und Keramiken. Die Erfindung eignet sich besonders zum Abtrennen von Siliciumscheiben (silicon wafers) von einem Einkristall.

Zum Erzeugen von Siliciumscheiben werden derzeit vorwiegend Drahtsägen verwendet, die mit einem Trennslurry arbeiten. Hierbei läuft ein 50 km bis 500 km langer Stahldraht spiralförmig über Drahtführungsrollen und bildet ein Drahtgatter. Als Trennläppmittel wird im allgemeinen ein Hartstoff, beispielsweise SiC in einer Trägerflüssigkeit verwendet. Es wird während des Schnittes zugeführt und durch die Drahtbewegung lose in den Schneidspalt transportiert. Je nach Schnittlänge und Vorschubsweg werden hierbei in einem mehrere Stunden dauernden Prozeß einige Hundert Scheiben gleichzeitig erzeugt. Der Sägedraht wird entweder über den ganzen Schnittverlauf in die gleiche Richtung oder hin und her bewegt (oszillierende Drahtbewegung), wobei beim Bewegen mit Richtungswechsel die Vorwärtsbewegung stets länger ausgeführt wird wie die Rückwärtsbewegung. Dadurch kommt auch ständig noch unbenutzter Sägedraht zum Einsatz. DE-A-196 38 991 offenbart ein solches Verfahren.

Ebenfalls zum Stand der Technik zählen Einzeldrahtschnittverfahren, bei denen der Sägedraht mit gebundenem Schneidkorn besetzt ist und nur ein einziger Einschnitt ins Werkstück erfolgt. Dem Dokument JP-A-10 138 114 kann so ein Sägedraht entnommen werden. Man kann zwischen Verfahren unterscheiden, bei denen eine Drahtschlaufe (endlos, gleichbleibende Bewegungsrichtung) verwendet wird und Verfahren, bei denen ein endlicher Sägedraht mit oszillierender Drahtbewegung verwendet wird. Bei den zuletzt genannten Verfahren wird der Sägedraht von einer Spule abgewickelt, läuft zum Werkstück und wird auf einer Empfängerspule wieder aufgewickelt.

Gegenstand der Erfindung ist ein Verfahren zum Abtrennen einer Vielzahl von Scheiben von einem sprödharten Werkstück durch Bewegen des Werkstücks mit einer bestimmten Vorschubgeschwindigkeit durch ein Drahtgatter einer Drahtsäge, wobei eine Kühlflüssigkeit unter dem Drahtgatter bereitgestellt wird, in die der Sägedraht des Drahtgatters beim Abtrennen der Scheiben eintaucht, das dadurch gekennzeichnet ist, daß das Drahtgatter von einem Sägedraht gebildet wird, der sich hin und her bewegt und mit gebundenem Schneidkorn besetzt ist.

Gegenstand der Erfindung ist auch eine Drahtsäge zum Abtrennen einer Vielzahl von Scheiben von einem sprödharten Werkstück, das durch ein Drahtgatter mit einer bestimmten Vorschubgeschwindigkeit bewegt wird, wobei das Drahtgatter von einem Sägedraht gebildet wird, der um Drahtführungsrollen gewickelt ist, und mit einem Reservoir, das mit Kühlflüssigkeit gefüllt und unter dem Drahtgatter derartig angeordnet ist, daß der Sägedraht des Drahtgatters beim Abtrennen der Scheiben in die Kühlflüssigkeit eintaucht, die dadurch gekennzeichnet ist, daß sich der Sägedraht hin und her bewegt und mit gebundenem Schneidkorn besetzt ist.

Die Erfindung ermöglicht das Abtrennen von Scheiben ohne aufwendige Slurry-Ver- und Entsorgung und dem damit verbundenen großen apparativen Aufwand und den zu berücksichtigenden ökologischen Problemen. Sie nützt den Umstand, daß gebundenes Korn schleifend einwirkt und deshalb effektiver zerspant, als die läppend einwirkenden Hartstoffe eines Slurry. Durch die Erfindung können insbesondere höhere Schnittleistungen, kürzere Prozeßzeiten und bessere Schnittqualitäten erreicht werden. Das vorgeschlagene Verfahren weist zudem nicht die Nachteile bekannter Einzeldrahtschnittverfahren auf, die unwirtschaftlich sind, da jeweils nur eine Scheibe erzeugt werden kann und die Schnittzeiten im Vergleich zu konkurrierenden Einzelschnittverfahren wie dem Innenlochsägen sehr lang sind.

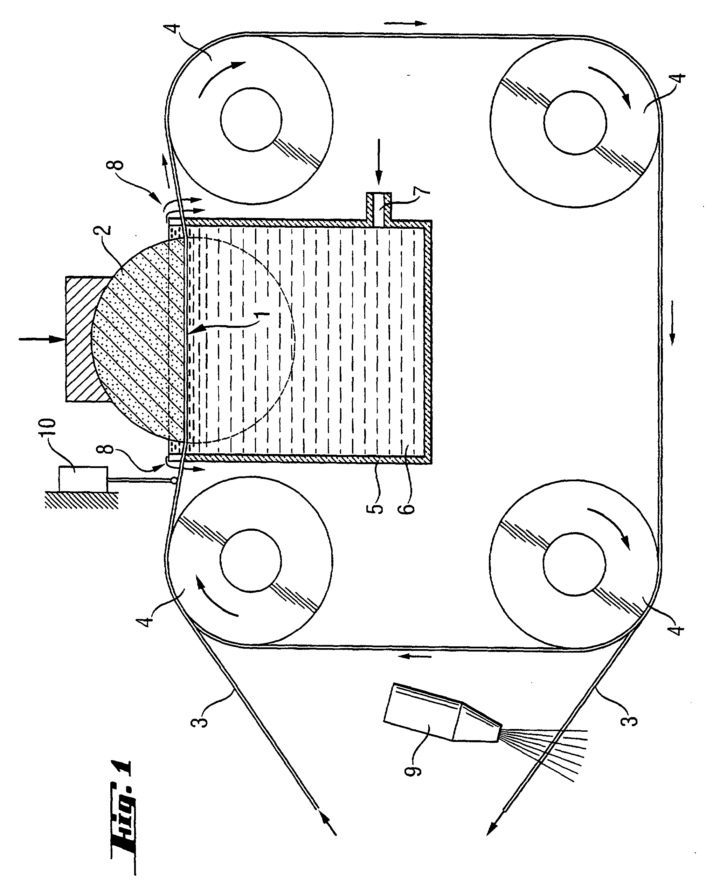

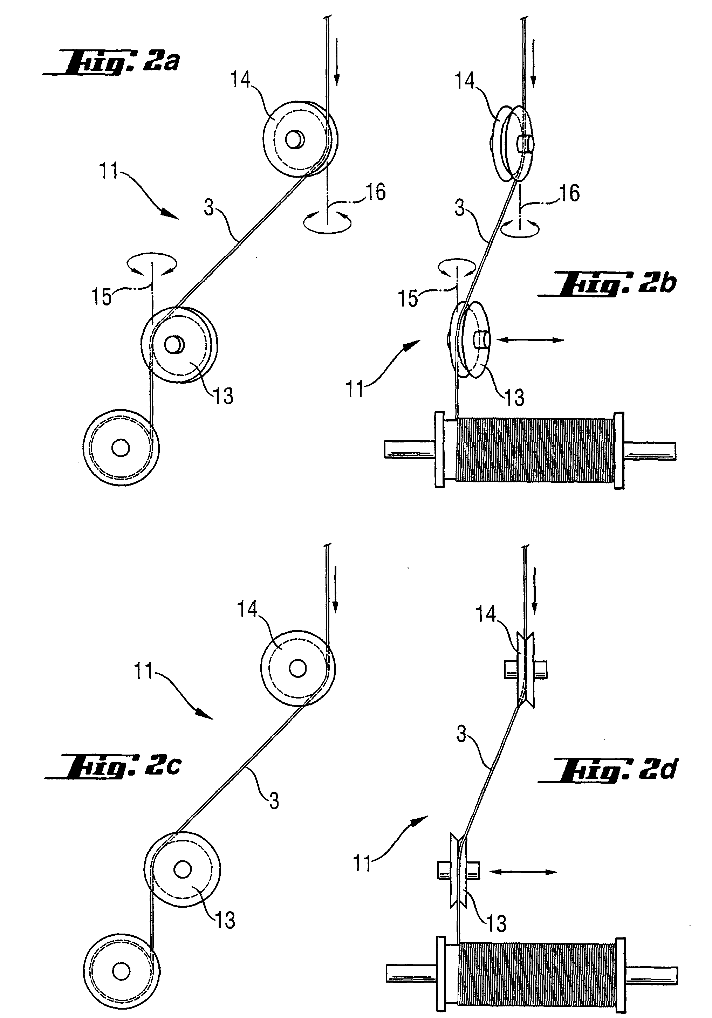

Die Erfindung wird nachfolgend an zwei Figuren näher erläutert. Figur 1 zeigt schematisch eine Drahtsäge, die zur Durchführung des erfindungsgemäßen Verfahrens geeignet ist. In Figur 2a, b ist ein bevorzugtes Merkmal der Drahtsäge in einer Vorder-ansicht und einer Seitenansicht dargestellt. Fig. 2c, d zeigt eine Variante gemäß Fig. 2a, b ohne entsprechende Merkmale.

Die Drahtsäge gemäß Fig.1 weist ein Drahtgatter 1 auf, durch das das Werkstück 2 mit einer bestimmten Vorschubgeschwindigkeit bewegt wird. Das Drahtgatter wird von einem Sägedraht 3 gebildet, der mit gebundenem Schneidkorn besetzt ist und um Drahtführungsrollen 4 gewickelt ist. Die Drahtsäge umfaßt ferner ein Reservoir 5, das mit Kühlflüssigkeit 6 gefüllt ist. Das Reservoir ist unter dem Drahtgatter 1 derartig angeordnet, daß der Sägedraht des Drahtgatters, der in das Werkstück 2 eingreift, beim Abtrennen von Scheiben in die Kühlflüssigkeit 6 eintaucht. Die Kühlflüssigkeit, vorzugsweise Wasser, wird zweckmäßigerweise in einem Kreislauf gehalten und gegebenenfalls filtriert. In der Figur sind nur der Zulauf 7 und der Ablauf 8 des Kühlmittelkreislaufs schematisch dargestellt.

Es wird ein mit abrassivem Schleifmittel, vorzugsweise mit Diamant beschichteter endlicher Sägedraht verwendet, der über Umlenkrollen eine hin- und her gehende Bewegung ausführt. Die Länge des Sägedrahtes muß so bemessen werden, daß ein Sägegatter mit einer gewünschten Länge bereitstellt werden kann und ausreichend Sägedraht für die Schnittbewegung zur Verfügung steht. Typischerweise wird Sägedraht benötigt, dessen Länge ungefähr der Länge entspricht, die zum Aufbau des Drahtgatters benötigt wird, plus mindestens 50 m. Weitere bevorzugte Parameter sind eine Dicke des mit Schneidkorn belegten Drahtes von 180 bis 230 µm, eine Drahtspannung von 10 bis 40 N, eine Drahtgeschwindigkeit von 8 bis 20 m/s, eine Drahtbeschleunigung von 0.5 bis 5 m/s², eine Drahtoszillation von größer als 100 m und ein Spulen- und Drahtführungsrollen-Durchmesser von größer als 100 mm.

Das Reservoir 6 ist vorzugsweise als Überlaufbecken, besonders bevorzugt als Kunststoffwanne ausgebildet. In diesem Fall kann der Sägedraht in den oberen Rand des Beckens einschneiden. Die Drahtsäge kann konstruktiv auch so ausgeführt sein, daß Teile des die Drahtführungsrollen haltenden Sägekopfes die seitlichen Begrenzungen des Überlaufbeckens bilden.

Beim Bewegen des Werkstücks in Vorschubrichtung wird der Sägedraht im Bereich des Drahtgatters unter die Oberfläche der Kühlflüssigkeit gedrückt. Dadurch läuft das Abtrennen der Scheiben vollständig in der Kühlflüssigkeit ab, so daß eine optimale Kühlung der Schneidspalte gewährleistet ist. Das Eintauchen des Sägedrahtes in die Kühlflüssigkeit dient nicht nur zur Kühlung, sondern begünstigt auch die Schmierung und die Spanabfuhr.

Ferner wird eine Einheit 9 zum Reinigen des Sägedrahts 3 vorgeschlagen, um die Spanräume zwischen dem Schneidkorn zu erhalten. Die Drahtreinigung dient auch dazu, Verschleppungen von Schlamm wie beispielsweise Silicium-Abrieb in den Wicklerbereich zu vermeiden, wodurch ein Verschleiß von Umlenkrollen und Spulen niedrig gehalten werden kann. Mit der Einheit 9 wird ein Reinigungsmedium, beispielsweise Wasser oder Luft unter erhötem Druck gegen den Sägedraht geführt. Besonders bevorzugt ist, daß die Einheit 9 mindestens eine Megaschalldüse umfaßt, die das eingesetzte Reinigungsmedium zu hochfrequenten Schwingungen anregt.

Von besonderem Vorteil ist es, die Schnittkraft in Vorschubsrichtung einzustellen und zu kontrollieren, um eine optimale Schneidkornbelastung während des Abtrennens der Scheiben sicherzustellen. Die Schnittkraft ergibt sich aus der gewählten Drahtspannung, der Vorschubsgeschwindigkeit und der dynamischen Nachgiebigkeit des Drahtgatters. Aufgrund der Nachgiebigkeit des Drahtgatters stellt sich proportional zur Vorschubskraft eine Durchbiegung des Sägedrahts ein, die gemessen werden kann. Die gemessene Durchbiegung wird vorzugsweise zur Regelung der Vorschubsgeschwindigkeit verwendet, wobei die Vorschubsgeschwindigkeit verringert wird, wenn sich die Durchbiegung erhöht, und umgekehrt. Die Drahtsäge ist deshalb vorzugsweise auch mit einer Einrichtung 10 zum Messen einer Auslenkung des Sägedrahts beim Abtrennen der Scheiben und zur Regelung der Vorschubgeschwindigkeit in Abhängigkeit der gemessenen Auslenkung ausgestattet.

Das Aufwickeln des Sägedrahtes auf eine Empfängerspule, beziehungsweise das Abwickeln des Sägedrahtes von einer Senderspule sollte vorzugsweise mit einer Verlegeeinheit durchgeführt werden, die sicherstellt, daß sich der Sägedraht nicht kreuzt und mit jeder Umlenkrollennut fluchtet, da ein schräg geführter Draht durch die häufige Bewegungsumkehr an der gleichen Drahtposition reißt. In Figur 2a, b ist eine solche Verlegeeinheit 11 in zwei unterschiedlichen Ansichten dargestellt (Fig. 2a Vorderansicht, Fig. 2b Seitenansicht). Sie umfaßt zwei Umlenkrollen 13 und 14, wobei die untere Umlenkrolle den Sägedraht auf einer Empfängerspule axial verlegt, beziehungsweise den Sägedraht von einer Senderspule aufnimmt. Der Doppelpfeil soll diese axiale Bewegung andeuten. Besonderes Merkmal der Umlenkrollen ist, daß sie um die Achsen 15 und 16 gekippt werden können. Der Kippmechanismus neigt die Achse der Umlenkrollen je nach Verlegeposition so, daß ein Laufen des Sägedrahtes senkrecht zur Rotationsachse der Umlenkrollen erreicht wird.

Zum Vergleich ist in Figur 2c, d eine entsprechende Verlegeeinheit dargestellt, der dieses Merkmal fehlt, wodurch der Sägedraht je nach Verlegeposition schräg von oder auf die Umlenkrollen läuft. Falls die Achsen von Umlenkrolle und Spule in einem Winkel von 90° angeordnet sind, kann jedoch auch eine derartig ausgebildete Verlegeeinheit benutzt werden, wobei die Bewegungsrichtung (Doppelpfeil) dann 90° zur Drehachse steht.

Erfindungsgemäß hergestellte Scheiben aus Silicium können durch Schleifen (einseitig, beidseitig oder beidseitig simultan), Kantenverrunden, Ätzen und Doppelseitenpolieren (nacheinander oder simultan) weiter bearbeitet werden. Bei Einsatz von diamantbesetzten Sägedrähten mit relativ feiner Körnung (20 µm und kleiner) sind besonders glatte und schädigungsarme Oberflächen herstellbar, so daß das Schleifen und/oder das Ätzen im vorstehend genannten Ablauf gegebenenfalls unterbleiben kann.

## Patentansprüche

1. Verfahren zum Abtrennen einer Vielzahl von Scheiben von einem sprödharten Werkstück (2) durch Bewegen des Werkstücks mit einer bestimmten Vorschubgeschwindigkeit durch ein Drahtgatter (1) einer Drahtsäge, wobei eine Kühlflüssigkeit (6) unter dem Drahtgatter bereitgestellt wird, in die der Sägedraht des Drahtgatters beim Abtrennen der Scheiben eintaucht, **dadurch gekennzeichnet, daß** das Drahtgatter (1) von einem Sägedraht (3) gebildet wird, der sich hin und her bewegt und mit gebundenem Schneidkorn besetzt ist.

2. Verfahren nach Anspruch 1, **dadurch gekennzeichnet, daß** das Werkstück (2) den Sägedraht (3) beim Abtrennen der Scheiben aus einer Ruhelage auslenkt, und die Vorschubgeschwindigkeit in Abhängigkeit der gemessenen Auslenkung des Sägedrahts geregelt wird.

3. Verfahren nach Anspruch 1 oder Anspruch 2, **dadurch gekennzeichnet, daß** der Sägedraht (3) über Umlenkrollen (13 und 14) auf eine Spule gewickelt wird, und eine der Umlenkrollen den Sägedraht auf der Spule axial verlegt, wobei diese Umlenkrolle und eine den Sägedraht an sie abgebende Umlenkrolle senkrecht zu ihren Drehachsen kippbar ausgeführt sind, so daß der Sägedraht zwischen der Spule und den beiden Umlenkrollen stets senkrecht zur Drehachse der Spule läuft.

4. Verfahren nach Anspruch 1 oder Anspruch 2, **dadurch gekennzeichnet, daß** der Sägedraht (3) über Umlenkrollen (13 und 14) von einer Spule gewickelt wird, und eine der Umlenkrollen den Sägedraht von der Spule aufnimmt, wobei diese Umlenkrolle und eine den Sägedraht von ihr empfangende Umlenkrolle senkrecht zu ihren Drehachsen kippbar ausgeführt sind, so daß der Sägedraht zwischen der Spule und den beiden Umlenkrollen stets senkrecht zur Drehachse der Spule läuft.

5. Verfahren nach einem der Ansprüche 1 bis 4, **dadurch gekennzeichnet, daß** der Sägedraht (3) mit Hilfe eines mit Megaschall beaufschlagten Reinigungsmediums gereinigt wird.

6. Verfahren nach einem der Ansprüche 1 bis 5, **dadurch gekennzeichnet, daß** die Scheiben im Anschluß an das Abtrennen in der Reihenfolge Kantenverrunden, Ätzen und Doppelseitenpolieren weiterbearbeitet werden.

7. Verfahren nach einem der Ansprüche 1 bis 5, **dadurch gekennzeichnet, daß** die Scheiben im Anschluß an das Abtrennen in der Reihenfolge Kantenverrunden und Doppelseitenpolieren weiterbearbeitet werden.

8. Drahtsäge zum Abtrennen einer Vielzahl von Scheiben von einem sprödharten Werkstück (2), das durch ein Drahtgatter (1) mit einer bestimmten Vorschubgeschwindigkeit bewegt wird, wobei das Drahtgatter von einem Sägedraht (3) gebildet wird, der um Drahtführungsrollen (4) gewickelt ist, und mit einem Reservoir (5), das mit Kühlflüssigkeit (6) gefüllt und unter dem Drahtgatter (1) derartig angeordnet ist, daß der Sägedraht (3) des Drahtgatters beim Abtrennen der Scheiben in die Kühlflüssigkeit (6) eintaucht, **dadurch gekennzeichnet, daß** sich der Sägedraht (3) hin und her bewegt und mit ge bundenem Schneidkom besetzt ist.

9. Drahtsäge nach Anspruch 8, **gekennzeichnet durch** eine Einrichtung (10) zum Messen einer Auslenkung des Sägedrahts (3) beim Abtrennen der Scheiben und zur Regelung der Vorschubgeschwindigkeit in Abhängigkeit der gemessenen Auslenkung.

10. Drahtsäge nach Anspruch 8 oder Anspruch 9, **gekennzeichnet durch** eine Verlegeeinheit (11) zum Aufwickeln des Sägedrahtes auf eine Spule, mit einer Umlenkrolle (13), die den Sägedraht auf der Spule axial verlegt, und mit einer den Sägedraht an diese Umlenkrolle abgebende Umlenkrolle (14), wobei die beiden Umlenkrollen um eine Achse kippbar ausgebildet sind, die senkrecht zur Drehachse der Umlenkrollen liegt.

11. Drahtsäge nach Anspruch 8 oder Anspruch 9, **gekennzeichnet durch** eine Verlegeeinheit (11) zum Abwickeln des Sägedrahtes (3) von einer Spule, mit einer Umlenkrolle (13), die den Sägedraht von der Spule aufnimmt, und mit einer den Sägedraht von dieser Umlenkrolle empfangenden Umlenkrolle (14), wobei die beiden Umlenkrollen um eine Achse kippbar ausgebildet sind, die senkrecht zur Drehachse der Umlenkrollen liegt.

12. Drahtsäge nach einem der Ansprüche 8 bis 11, **gekennzeichnet durch** eine Einheit (9) zum Reinigen des Sägedrahtes (3), die mindestens eine Megaschalldüse umfaßt.

## Claims

1. Method for cutting a multiplicity of discs off a hard brittle workpiece (2), by moving the workpiece at a defined feed rate through a wire web (1) of a wire saw, a cooling liquid (6) being provided beneath the wire web, in which liquid the saw wire of the wire web is immersed when cutting off the discs, **characterized in that** the wire web (1) is formed by a saw wire (3) which moves in a reciprocating manner and is covered with bonded abrasive grain.

2. Method according to Claim 1, **characterized in that** the workpiece (2), when the discs are being cut off, deflects the saw wire (3) out of an at-rest position, and the feed rate is controlled as a function of the measured deflection of the saw wire.

3. Method according to Claim 1 or Claim 2, **characterized in that** the saw wire (3) is wound onto a spool via guide rollers (13 and 14), and one of the guide rollers receives the saw wire from the spool, this guide roller and a guide roller which receives the saw wire therefrom being designed so that they can tilt perpendicular to their axes of rotation, so that the saw wire between the spool and the two guide rollers always runs perpendicular to the axis of rotation of the spool.

4. Method according to Claim 1 or 2, **characterized in that** the saw wire (3) is wound from a spool via guide rollers (13 and 14), and one of the guide rollers (13 and 14) takes the saw wire from the spool, this guide roller and a guide roller which receives the saw wire therefrom being designed so that they can tilt. perpendicular to their axes of rotation, so that the saw wire between the spool and the two guide rollers always runs perpendicular to the axis of rotation of the spool.

5. Method according to one of Claims 1 to 4, **characterized in that** the saw wire (3) is cleaned with the aid of a cleaning medium to which megasound is applied.

6. Method according to one of Claims 1 to 5, **characterized in that** the discs, after they have been cut off, are processed further in the following order: edge rounding, etching and double-side polishing.

7. Method according to one of Claims 1 to 5, **characterized in that** the discs, after they have been cut off, are processed further in the following order: edge rounding and double-side polishing.

8. Wire saw for cutting a multiplicity of discs off a hard brittle workpiece (2), which is moved through a wire web (1) at a defined feed rate, the wire web being formed by a saw wire (3) which is wound around wire-guidance rollers (4), and having a reservoir (5) which is filled with cooling liquid (6) and is arranged beneath the wire web (1), in such a manner that the saw wire (3) of the wire web is immersed in the cooling liquid (6) when the discs are being cut off, **characterized in that** the saw wire (3) is moved in a reciprocating manner and is covered with. bonded abrasive grain.

9. Wire saw according to Claim 8, **characterized by** a device (10) for measuring a deflection of the saw wire (3) when the discs are being cut off and for controlling the feed rate as a function of the measured deflection.

10. Wire saw according to Claim 8 or Claim 9, **characterized by** a displacer unit (11) for winding the saw wire onto a spool, with a guide roller (13) which axially displaces the saw wire on the spool, and with a guide roller (14) which delivers the saw wire to this guide roller, the two guide rollers being designed so that they can tilt about an axis which is perpendicular to the axis of rotation of the guide rollers.

11. Wire saw according to Claim 8 or 9, **characterized by** a displacer unit (11) for unwinding the saw wire (3) from a spool, with a guide roller (13) which takes the saw wire from the spool, and with a guide roller (14) which receives the saw wire from this guide roller, the two guide rollers being designed so that they can tilt about an axis which is perpendicular to the axis of rotation of the guide rollers.

12. Wire saw according to one of Claims 8 to 11, **characterized by** a unit (9) for cleaning the saw wire (3) which comprises at least one megasound nozzle.

## Revendications

1. Procédé pour couper des plaquettes d'un lingot dur et cassant (2) en faisant passer le lingot avec une vitesse d'avance déterminée à travers une grille de fils (1) d'une scie à fil, dans lequel un liquide de refroidissement (6) est préparé en dessous de la grille de fils et dans lequel plonge le fil de scie de la grille de fils lors de la coupe des plaquettes, **caractérisé en ce que** la grille de fils (1) est formée par un fil de scie (3), qui se déplace en mouvement alternatif et qui est garni de grains de coupe liés.

2. Procédé suivant la revendication 1, **caractérisé en ce que** le lingot (2) dévie le fil de scie (3) hors d'une position de repos pendant la coupe des plaquettes, et la vitesse d'avance est régulée en fonction de la déviation mesurée du fil de scie.

3. Procédé suivant la revendication 1 ou la revendication 2, **caractérisé en ce que** le fil de scie (3) est enroulé sur une bobine via des poulies de renvoi (13 et 14), et une des poulies de renvoi déplace le fil de scie axialement sur la bobine, cette poulie de renvoi et une poulie de renvoi lui délivrant le fil de scie pouvant pivoter perpendiculairement à leurs axes de rotation, de telle manière que le fil de scie défile toujours perpendiculairement à l'axe de rotation de la bobine entre la bobine et les deux poulies de renvoi.

4. Procédé suivant la revendication 1 ou la revendication 2, **caractérisé en ce que** le fil de scie (3) est déroulé d'une bobine via des poulies de renvoi (13 et 14), et une des poulies de renvoi reçoit le fil de scie de la bobine, cette poulie de renvoi et une poulie de renvoi recevant de celle-ci le fil de scie pouvant pivoter perpendiculairement à leurs axes de rotation, de telle manière que le fil de scie défile toujours perpendiculairement à l'axe de rotation de la bobine entre la bobine et les deux poulies de renvoi.

5. Procédé suivant l'une quelconque des revendications 1 à 4, **caractérisé en ce que** le fil de scie (3) est nettoyé à l'aide d'un fluide de nettoyage soumis à de très hautes fréquences.

6. Procédé suivant l'une quelconque des revendications 1 à 5, **caractérisé en ce qu'**à la suite de la coupe, les plaquettes sont ensuite soumises à une séquence de traitement d'arrondissement des arêtes, d'attaque à l'acide et de polissage des deux faces.

7. Procédé suivant l'une quelconque des revendications 1 à 5, **caractérisé en ce qu'**à la suite de la coupe, les plaquettes sont ensuite soumises à une séquence de traitement d'arrondissement des arêtes et de polissage des deux faces.

8. Scie à fil pour couper des plaquettes d'un lingot dur et cassant (2), qui se déplace à travers une grille de fils (1) avec une vitesse d'avance déterminée, dans laquelle la grille de fils est formée par un fil de scie (3), qui est enroulé autour de poulies de guidage de fil (4), et avec un réservoir (5), qui est rempli d'un liquide de refroidissement (6) et qui est disposé en dessous de la grille de fils (1), d'une manière telle que le fil de scie (3) de la grille de fils plonge dans le liquide de refroidissement (6) lors de la coupe des plaquettes, **caractérisée en ce que** le fil de scie (3) se déplace en mouvement alternatif et est garni de grains de coupe liés.

9. Scie à fil suivant la revendication 8, **caractérisée par** un dispositif (10) pour mesurer une déviation du fil de scie (3) lors de la coupe des plaquettes et pour réguler la vitesse d'avance en fonction de la déviation mesurée.

10. Scie à fil suivant la revendication 8 ou la revendication 9, **caractérisée par** une unité de déplacement (11) pour enrouler le fil de scie sur une bobine, avec une poulie de renvoi (13), qui déplace le fil de scie axialement sur la bobine, et avec une poulie de renvoi (14) délivrant le fil de scie à cette poulie de renvoi, les deux poulies de renvoi pouvant pivoter autour d'un axe, qui est perpendiculaire à l'axe de rotation des poulies de renvoi.

11. Scie à fil suivant la revendication 8 ou la revendication 9, **caractérisée par** une unité de déplacement (11) pour dérouler le fil de scie (3) d'une bobine, avec une poulie de renvoi (13), qui reçoit le fil de scie de la bobine, et avec une poulie de renvoi (14) recevant le fil de scie de cette poulie de renvoi, les deux poulies de renvoi pouvant pivoter autour d'un axe, qui est perpendiculaire à l'axe de rotation des poulies de renvoi.

12. Scie à fil suivant l'une quelconque des revendications 8 à 11, **caractérisée par** une unité (9) pour nettoyer le fil de scie (3), qui comprend au moins une tuyère à très hautes fréquences.
